# EUROPEAN PATENT APPLICATION

(11) **EP 1 037 062 A2**
(43) Date of publication of application: **20.09.2000**
(21) Application number: 00301787.8
(22) Date of filing: 03.03.2000
(51) Int. Cl.: G01R 31/28

(54) **Apparatus for heating electronic components**

(30) Priority: 06.03.1999 GB 9905093
(71) Applicant: Pace Micro Technology PLC, Shipley, West Yorkshire BD18 3LF (GB)
(72) Inventor: Rodwell, John, Long Lee, Keighley BD21 9UZ (GB); Pawlak, Richard, Eccleshill, Bradford BD2 4JL (GB); Skow, Paul, Bramley, Leeds LS13 3LL (GB)
(74) Representative: Wood, Graham

(57) **Abstract**

A test fixture for the testing of electronic assemblies (6). The test fixture including locating means to allow the electronic assembly or assemblies (6) placed therein to be located in the required test locations. The fixture also includes at least one heating means (2) which is located with respect to the electronic assemblies (6) to contact with one or a plurality of the components which are required to be heated during the testing of the electronic assembly (6).

## Description

The present invention relates to a means for heating an integrated circuit of the type used as parts of an electronic assembly to provide a particular function such as, although not exclusively, an electronic assembly for use in a television signal decoder although this is only one such use and the invention as herein described is envisaged having wide ranging use throughout the electronic assembly manufacturing industry.

In the assembly of electronic assemblies on printed circuit boards, it is required that the various components which make up the electronic assembly are tested. As parts of this integrated circuit chip arc required to be tested either on each board or at regular intervals to ensure that the chip which is provided on the electronic assembly is performing the required function within the required parameters.

Although IC's may be tested by the manufacturer of the same it is normally the case that they are required to be checked by the assembler who can assemble a number of integrated circuits into one electronic assembly. A problem with this is that in some instances the integrated circuits can only properly be tested when they arc at operating temperatures which can be significantly higher than the ambient temperature during the manufacturing process. This therefore means that if the integrated circuit chips which arc of this type are to be properly tested then the electronic assembly is required to be tested in normal operating conditions and when the integrated circuit chip is at its maximum temperature. This can take a number of hours of operation to reach and is therefore impractical in manufacturing conditions so that only a relatively small sample of the integrated chip can be tested in this manner which is also held to be unacceptable.

A further problem is that the general heating of the electronic assembly is not acceptable as other components do not react well to being heated.

The aim of the present invention is to provide a means for heating an integrated circuit to allow the same to be tested in conditions broadly similar to the operating conditions of the electronic assembly without unduly affecting the conditions or temperatures of other components on the electronic assembly and to allow the testing of the integrated circuit at the higher temperatures within normal manufacturing test times.

In a first aspect of the invention there is provided a test fixture for the testing of an electronic assembly or assemblies comprising at least one component which is required to be heated to test the same, said test fixture including locating means to allow the electronic assembly or assemblies to be placed and located in a test position and characterised in that said fixture includes at least one heating means which is located with respect to the fixture and electronic assembly or assemblies to impart heat to the least one component which is to be heated during the testing of the electronic assembly or assemblies.

In one embodiment, the test fixture includes a means which is closed onto the electronic assembly or assemblies when the same are held in test locations and the temperature controlled heating means are located on the lid which is placed down onto the electronic assemblies prior to commencement of the test and said heating means are located with respect to the electronic assemblies so as to contact onto or in proximity with the one or plurality of components which are to be heated.

In use therefore the heating means adds to the temperature which may already be reached under the normal operating conditions of the electronic assembly in the normal manufacturing test time which can be for example 1 minute, but also accelerates the temperature of the components to the upper limit of the heat of the same during prolonged operation of the electronic assembly so that the component can be checked and tested in the normal manufacturing test time at its higher operating limits which was not previously possible.

In one embodiment the heating means is a temperature controlled pad which is of a size so as to contact onto the area of the integrated circuit. The pad can include a heater element, a heat transfer plate and a heat transfer contact pad in one embodiment. Typically the operation of the heater element in terms of the heating rate and the time of operation can be controlled by a temperature control module and if there are a plurality of said heating means provided for a number of components in each electronic assembly the rate of heating and the time of heating may be controlled by the same module if possible or alternatively, if different heating rates and temperatures are required, separate operating conditions are set for each of the heating means provided.

Typically the components which are checked are integrated circuit chips on the electronic assemblies.

In one embodiment the position of the heating means with respect to the test fixture is adjustable to allow the heating means to be used to heat components in differing positions. If a plurality of heating means are provided in the test fixture each of the same can be positionally adjustable in said fixture.

In a further aspect of the invention there is provided a method of testing at least one component for an electronic assembly, said component required to be tested in normal operating conditions wherein said method includes the step of bringing the component into contact, or proximity, with a heating means, said heating means operated to impart heat to the component to bring the same to the temperature of normal operating conditions during the test of the electronic assembly.

Typically the said component is tested when it is joined to and part of the electronic assembly and during the testing of the electronic assembly operation, thus providing the reduction in test time which , in turn, leads to significant cost savings.

Specific embodiments of the invention are now described with reference to the accompanying drawings, wherein:-
Figure 1 illustrates a heating arrangement according to one embodiment of the invention;
Figure 2 illustrates in greater detail the heating means of the invention; and
Figure 3 illustrates a plan view of the heating means.

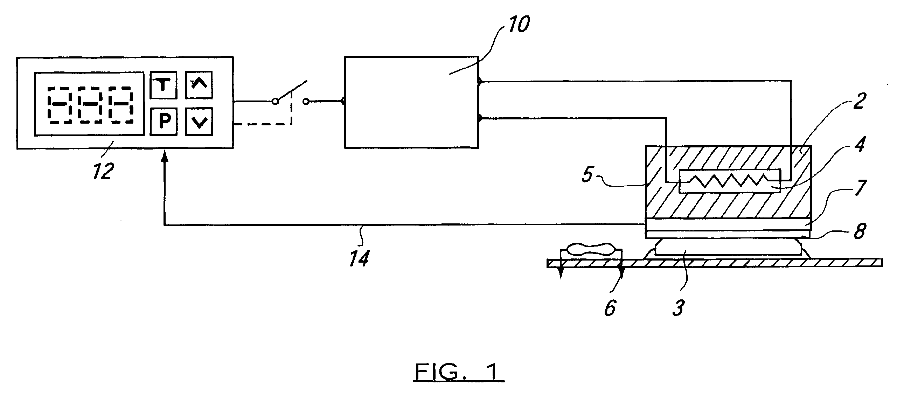

Referring firstly to Figure 1 there is illustrated a heating means 2 shown applied to an integrated circuit chip 3 on an electronic assembly 6. The heating means 2 comprises a heater element 4 in a block 5 connected with a heat transfer plate 7 which in turn is connected with the heat transfer contact pad 8 which is applied to the component 3 to heat the same. The heater element 4 is connected to a power source 10 which is selectively operated by a temperature control module 12 which controls the switching on and off of the heater element, the rate of heating, the temperature to be attained and the duration of heating. There is also provided a feed back from the heating means 14 to the temperature control module as shown.

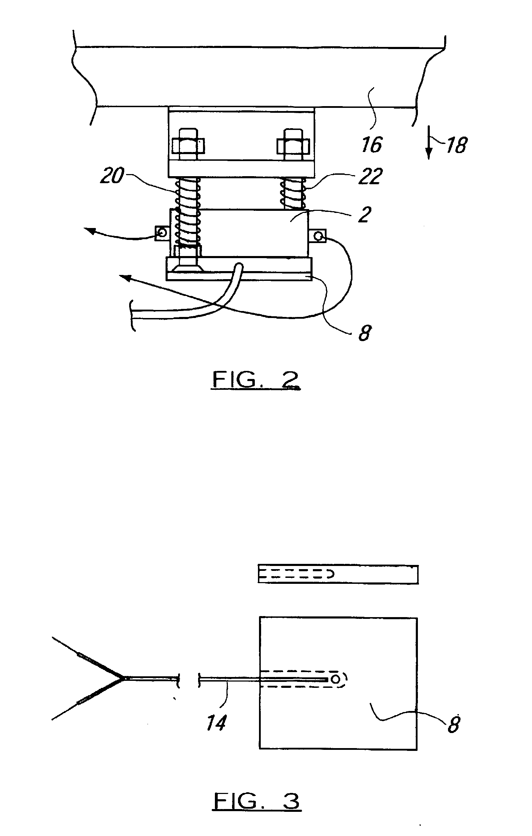

Figure 2 illustrates heating means 2 in greater detail and shows the heating means fixed as part of a test fixture lid 16 so that when the lid of the test fixture is closed in the direction 18 onto the remaining for the test fixture in which one or a number of electronic assemblies are positioned for testing so the heating means 2 and in particular the pad 8 is located on the test fixture with respect to the electronic assemblies and the components to be heated thereon so that the pad 8 is brought down onto the component to be heated in the required location. Biasing means 20, 22 arc provided to ensure that the contact pad is maintained in contact with the component during the heating process. As shown in Figure 3, the feedback 14 from the heater pad allows the heat at the pad to be monitored so as to ensure that the component which is to be tested is being heated to the required temperature during the manufacturing test time and also to ensure that the same is not overheated so that the results of the test of the chip and the electronic assembly in general during the manufacturing test time can be relied upon.

By providing for the heating of the components and in particular integrated circuits, the heating means adds to the temperature which has already been reached under normal operating conditions during the manufacturing test time which the electronic assembly or assemblies are operated but also allows the components which are required to be heated to an upper limit which would normally only happen after a number of hours of use and therefore allows the same to be tested during the relatively short manufacturing test time at conditions which have not previously been possible to test in large scale manufacturing facilities. This therefore enables the manufacturing function to pass or fail the component and/or electronic assembly in the mass production environment with the benefit of operating the components at their maximum temperature limits and still do so within the manufacturing test times which are available and at temperatures which would not be detected reliably for several hours in normal operation without the heating means.

## Claims

1. A test fixture for the testing of an electronic assembly or assemblies comprising at least one component which is required to be heated to test the same, said test fixture including locating means to allow the electronic assembly or assemblies (6) to be placed and located in a test position and characterised in that said fixture includes at least one heating means (2) which is located with respect to the fixture and electronic assembly or assemblies to impart heat to the least one component which is to be heated during the testing of the electronic assembly or assemblies (6).

2. A test fixture according to claim 1 characterised in that the test heating means can be temperature and/or time controlled so as to control the heat of the at least one component during the test of the same.

3. A test fixture according to claim 1 wherein the test fixture includes a lid which is closed onto the electronic assembly or assemblies (6) when the same are in the test position and the heating means (2) are located on the lid (16) so as to contact with or be held in proximity with the at least one component which is to be heated.

4. A test fixture according to claim 1 wherein biasing means (20, 22) are provided to ensure the heating means (2) is maintained in contact with the component during the imparting of heat thereto.

5. A test fixture according to claim 1 characterised in that the heating means (2) allows the electronic assembly (6) and/or at least one component to be brought to the normal operating temperature more quickly than would be the case if the electronic assembly was operated in a normal manner.

6. A test fixture according to claim 1 characterised in that the heating means (2) heats the electronic assembly (6) to a predetermined highest operating temperature level.

7. A test fixture according to any of the preceding claims characterised in that the heating means (2) is a pad of material.

8. A test fixture according to claim 7 characterised in that the area of the pad at least equals the area of the at least one component to be heated.

9. A test fixture according to claim 1 wherein the heating means includes a heater element (4), a heat transfer plate (7) and a heat transfer contact pad (8).

10. A test fixture according to any of the preceding claims characterised in that the temperature, heating rate and switch on/off mechanism of the heating means is controlled by a temperature control module (12).

11. A test fixture according to any of the preceding claims characterised in that the test fixture includes a plurality of heating means, each located with respect to component in the electronic assembly or assemblies which is to be heated.

12. A test fixture according to claim 11 characterised in that a single temperature control module (12) is provided to operate the plurality of heating means (2) for a number of components in one or more electronic assemblies (6).

13. A test fixture according to claim 11 wherein one or more temperature control modules (12) are provided, each of said one or more modules (12) controlling operating conditions for each of the heating means (2) provided.

14. A test fixture according to claim 10 wherein a feedback (14) link is provided from the heating means (2) to the temperature control module (12).

15. A test fixture according to claim 1 wherein the at least one component to be heated is an integrated circuit chip (3).

16. A test fixture according to claim 1 characterised in that the position of the heating means with respect to the test fixture is adjustable to allow the heating means to be used to heat components in differing positions.

17. A test fixture according to claim 16 characterised in the that a plurality of heating means are provided in the test fixture and each of the same are positionally adjustable in said fixture.

18. A method of testing at least one component for an electronic assembly, said component required to be tested in normal operating conditions wherein said method includes the step of bringing the component into contact, or proximity, with a heating means, said heating means operated to impart heat to the component to bring the same to the temperature of normal operating conditions during the test of the electronic assembly.

19. A method according to claim 18 characterised in that said component is tested when part of the electronic assembly and during the testing of the electronic assembly operation.
